Europäisches Patentamt

European Patent Office

Office européen des brevets

(19)

(11) Publication number : **0 545 602 A1**

# (12) EUROPEAN PATENT APPLICATION

(21) Application number : 92310724.7

(22) Date of filing : 24.11.92

(51) Int. Cl.$^5$ : **H01L 21/285**

(30) Priority : 26.11.91 US 800855

(43) Date of publication of application :
09.06.93 Bulletin 93/23

(84) Designated Contracting States :
DE FR GB IT

(71) Applicant : SGS-THOMSON
MICROELECTRONICS, INC.
1310 Electronics Drive
Carrollton Texas 75006 (US)

(72) Inventor : Dixit, Girish A.
18175 Midway Road No. 159
Dallas, Denton County, Texas 75287 (US)
Inventor : Liou, Fu-Tai
2127 Lansdown Drive
Carrolton, Denton County, Texas 75010 (US)
Inventor : Wei, Che-Chia
4313 Purdue Circle
Plano, Collin County, Texas 75093 (US)
Inventor : Chen, Fusen
370 Elan Village Drive No. 116
San Jose, California 95035 (US)

(74) Representative : Palmer, Roger et al
PAGE, WHITE & FARRER 54 Doughty Street
London WC1N 2LS (GB)

(54) Method for forming barrier metal layers.

(57)   A method for forming interlevel contacts in integrated circuits includes the formation of a titanium nitride layer (26) prior to formation of an overlying conductive layer of a material such as polycrystalline silicon or a metal. In one approach, CVD titanium nitride (26) is deposited over a partially formed integrated circuit device and in a contact opening (20). The titanium nitride layer (26) is then exposed to an atmosphere containing oxygen, so that oxygen atoms diffuse into the titanium nitride layer (26). This may be done in conjunction with an annealing step. In another embodiment, layers of titanium (28) and titanium nitride (30) are sequentially sputtered onto the device. The nitride layer may then be exposed to an oxygen ambient, or the oxygen may be incorporated into the titanium nitride layer during the sputter deposition.

FIG 4(b)

EP 0 545 602 A1

The present invention relates generally to the formation of integrated circuit devices, and more specifically to the formation of low resistance interlevel contact sensitive devices.

In integrated circuit devices, contact resistance is between interconnect levels is important. This is especially true in small devices, in which the small areas available for interlevel contacts can result in resistances high enough to adversely impact device performance. It is also important to provide a diffusion barrier between aluminum and silicon to prevent silicon spiking, especially with the shallow junctions prevalent with high density devices. Many different techniques have been proposed and implemented to reduce contact resistances, while simultaneously minimizing interdiffusion of underlying silicon atoms and aluminum atoms from a metal interconnect structure.

One approach is to deposit a barrier metal in the contact prior to deposition of an aluminum interconnect layer. When a barrier metal such as titanium is used, it can be silicided in order to reduce the contact resistance. The titanium can also be used to form a barrier layer. One approach which has been used in the past is to deposit titanium over the integrated circuit device after contact openings have been formed, and then anneal the titanium in a nitrogen ambient atmosphere. This causes silicidation of the titanium in the contact opening, and forms a diffusion barrier layer of titanium nitride in the upper portions of the titanium layer. Thus, portions of the titanium layer are converted to titanium nitride while other portions are simultaneously converted to titanium silicide.

While this approach provides enhanced barrier performance, the quality of the titanium nitride barrier in preventing migration of aluminum in silicon atoms is not as good as might be desired. With the conversion process described above, only a very thin top layer of the titanium is converted to stochiometric (1:1) titanium nitride. Below this thin top layer, typically approximately 20 angstroms thick, the ratio of nitrogen to titanium is relatively low. Thus the majority of the nitride layer is actually $TiN_x$, where x typically has a value in the range $0.3 < x < 0.7$. As is realized by those skilled in the art, providing substantially (1:1) titanium nitride for a substantial thickness of the converted nitride layer would provide improved barrier properties.

It would therefore be desirable to provide a technique for forming a titanium nitride barrier layer which has improved properties over prior art techniques. It is extremely desirable for such a technique to be compatible with current device processing techniques.

Therefore, according to the present invention, a method for forming interlevel contacts in integrated circuits includes the formation of a titanium nitride layer prior to formation of an overlying conductive layer of a material such as polycrystalline silicon or a metal. In one approach, CVD titanium nitride is deposited over a partially formed integrated circuit device and in a contact opening. The titanium nitride layer is then exposed to an atmosphere containing oxygen, so that oxygen atoms diffuse into the titanium nitride layer. This may be done in conjunction with an annealing step. In another embodiment, layers of titanium and titanium nitride are sequentially sputtered onto the device. The nitride layer may then be exposed to various oxygen treatments, or the oxygen may be incorporated into the titanium nitride layer during the sputter deposition.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

Figures 1 - 3 illustrate sections of an integrated circuit device during formation of contacts in accordance with the present invention; and

Figure 4 describes techniques for forming portions of the inventive method in flowchart form.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

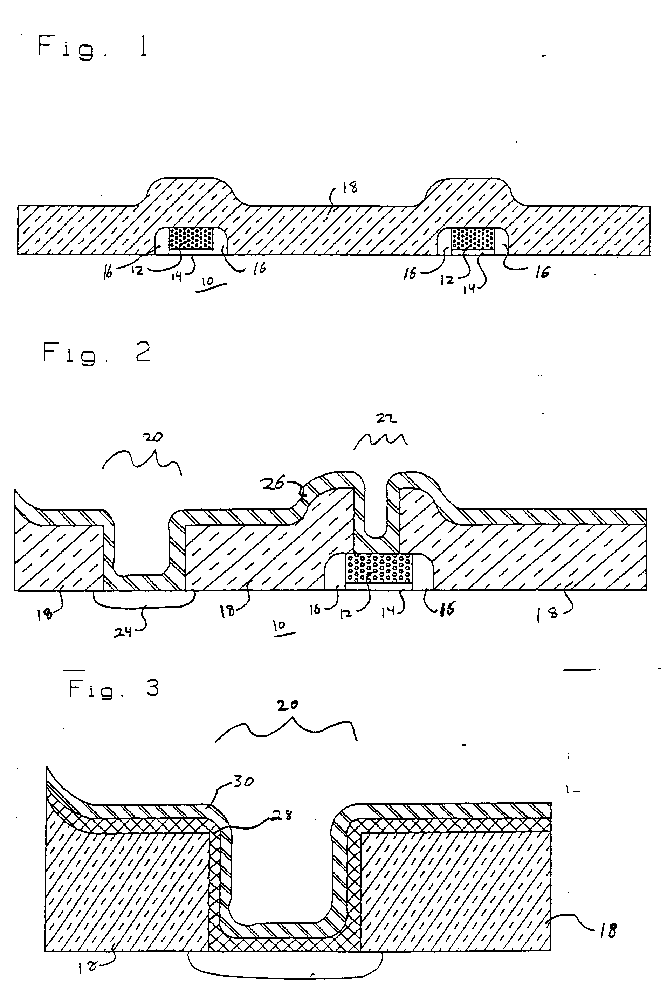

Referring to Figure 1, an integrated circuit device is to be formed in a substrate 10. Gate electrodes 12 are formed over the substrate 10 and spaced therefrom by gate oxide layer 14. Sidewall spacers 16 are formed along side the gate electrodes 12 as known in the art. An interlevel insulating layer 18 is formed over the entire surface of the device. Interlevel insulating layer 18 can be, for example, a conformally deposited undoped oxide, a reflow glass or spin on glass, or a combination of different insulating layers. Formation of the structures described so far are conventional, and well known in the art.

Referring to Figure 2 an enlarged view of the section shown in Figure 1 is illustrated. Openings 20 and 22 are formed through the interlevel insulating layer 18. Opening 20 contacts the substrate 10 while opening 22 exposes a portion of the gate electrode 12.

In one preferred embodiment, those portions of the substrate 10 exposed in the opening 20 are silicided to form a silicided contact region 24. A layer 26

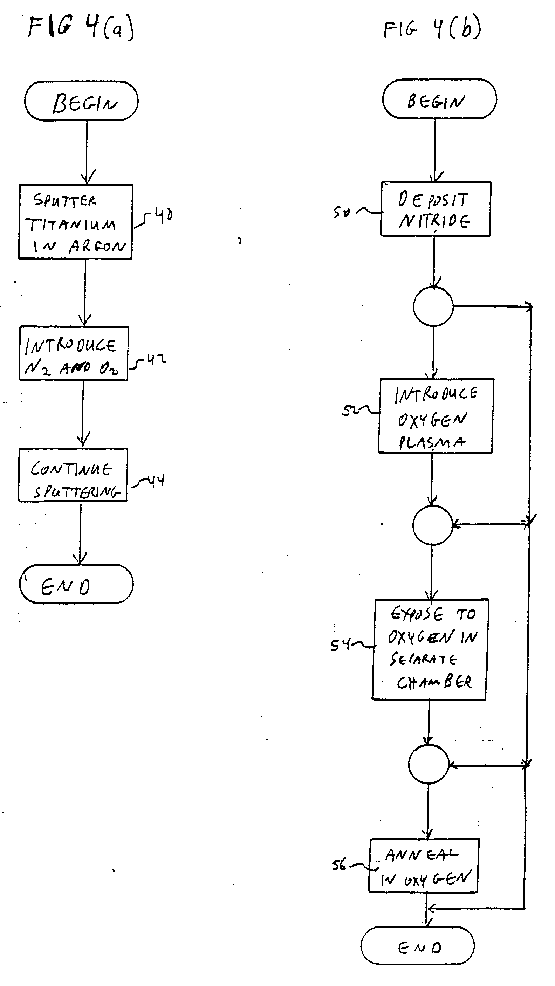

of CVD nitride is then deposited over the surface of the device. This conformal layer 26 fills the sides and bottoms of the openings 20, 22, and provides a diffusion barrier for a metal interconnect layer (not shown) to be deposited later over the device. Once the CVD nitride 26 has been deposited, a number of process alternatives are provided for by the present invention. These are discussed in more detail in connection with Figure 4, but generally include the introduction of oxygen into the nitride layer 26. A small amount of oxygen diffuses into the nitride layer 26, improving its resistance to the migration of silicon and aluminum atoms during later processing steps.

Referring to Figure 3 an alternative nitride formation technique is shown. Once the contact opening 20 has been formed, the wafer containing the integrated circuit is placed into a sputtering machine. A titanium layer 28 is sputtered over the device in an argon atmosphere, preferably to a thickness of approximately 600 angstroms. Nitrogen is then introduced into the atmosphere of the sputtering chamber, while deposition of the titanium continues. This forms a titanium nitride layer 30 over the surface of the device, preferably to a thickness of approximately 1000 angstroms. After formation of the nitride layer 30, the device is subjected to a thermal process, preferably a rapid thermal anneal, which forms a silicide region 32 below the opening 20.

Since nitrogen was present to react with the titanium during its deposition, the entire thickness of the nitride layer 30 is substantially stochiometric (1:1). This provides an improved diffusion barrier when compared with prior art techniques of converting a previously deposited titanium layer to titanium nitride. Deposition of the stochiometric nitride layer also occurs with the alternative arrangement shown in Figure 2.

In both of the embodiments described in Figures 2 and 3, the wafer containing the integrated circuit device is preferably exposed to an atmosphere containing oxygen after formation of either the nitride layer 26 or the nitride layer 30. As described above, this can be performed in conjunction with a thermal treatment to enhance the diffusion of oxygen atoms into the nitride layer 26, 30. Since, prior to oxygen diffusion, the nitride layer was substantially stochiometric, the resulting layer still contains approximately even proportions of titanium and nitrogen, with small amounts of oxygen. This results in a nitride layer having a formula of $TiN_xO_y$, where x is fairly close to 1 and y is very small. For example, x could be approximately 0.9 with y equal to approximately 0.1.

With either of the embodiments described in connection with Figures 2 and 3, oxygen can actually be included in the titanium nitride layers 26 and 30 as they are formed. When the nitrogen is introduced into the atmosphere of the sputtering chamber, small amounts of oxygen may also be introduced. This will cause small amounts of oxygen to be formed directly in the titanium nitride layer 30, so that a later oxygen diffusion step is not required. With the method of Figure 3, it remains desirable to perform a thermal anneal of the device in order to form the silicide layer region 32 which improves contact resistance.

Referring to Figure 4, two flow charts are shown which illustrate some of the process steps just described. Figure 4(a) illustrates the alternative shown in connection with Figure 3. Once the opening has been formed, titanium is sputtered onto the device in argon 40. While the sputtering continues, nitrogen and oxygen are introduced into the atmosphere of the sputtering chamber 42. Sputtering continues 44, forming a nitride layer having small amounts of oxygen included therein. If desired, the oxygen may be left out when the nitrogen is introduced in step 42, and diffused into the resulting nitride layer during the later anneal step.

Figure 4(b) illustrates several optional steps which can be used to introduce oxygen into the titanium nitride layer as described above. Initially, the titanium nitride layer is deposited 50. In any of the preferred embodiments, small amounts of oxygen may be deposited with the titanium nitride layer, but this discussion will assume that this was not the case. The flow lines of the flow chart of Figure 4(b) may be followed in any combination. Thus, oxygen may be introduced into the nitride layer in a plasma environment 52 after the formation of the nitride layer 26 or 30 has been completed. After sputtering or CVD nitride layer formation, the wafer containing the device may be moved to a separate chamber in a multichamber machine, and exposed to oxygen in such chamber 54. Finally, the wafer may be moved to a rapid thermal processor, and subjected to an anneal in an ambient containing nitrogen with small amounts of oxygen.

As illustrated in the flowchart, the three oxygen diffusion steps 52, 54, 56 may be selected and performed in any combination. In addition, any of them can be performed on a titanium nitride layer 26, 30 which was formed with oxygen initially available in the ambient atmosphere during sputtering or CVD deposition.

The oxygen plasma step 52 is typically performed after deposition is complete, and may be performed at a partial pressure of oxygen of approximately $10^{-5}$ torr to $10^{-2}$ torr, at a temperature of between 100°C and 500°C. If the wafer is moved to a separate chamber (step 54), the wafer may be exposed to an atmosphere of oxygen and argon at a temperature of between approximately room temperature and 500°C. A thermal anneal step in oxygen 56 is preferably performed in an atmosphere containing nitrogen and oxygen at a temperature in the range of approximately 450° to 750°C.

As will be appreciated by those skilled in the art, formation of the titanium nitride layer according to the described embodiments results in an improved diffusion barrier layer. This is believed to be caused by a stuffing of the grain boundaries of the titanium nitride by oxygen and nitrogen atoms during and after the nitride layer formation. This inhibits the mobility of aluminum and silicon atoms through the nitride layer between grain boundaries.

As will be appreciated by those skilled in the art, the various described techniques are easily performed using standard process flows and do not require any special equipment. A thicker layer of substantially stochiometric titanium nitride is formed than in the case of prior art techniques, and an improved diffusion barrier layer results. This improved diffusion barrier minimizes intermingling of aluminum and silicon atoms at contact regions, preventing detrimental side affects of such intermingling as is known in the art.

While the invention has been particularly shown and described with reference to a preferred embodiment, it will be understood by those skilled in the art that various changes in form and detail may be made therein without departing from the spirit and scope of the invention.

**Claims**

1. A method for forming a barrier layer on an integrated circuit device, comprising the steps of:
   forming an insulating layer over the device;
   forming an opening through the insulating layer to expose a portion of an underlying conducting layer;
   forming a layer of titanium nitride over the insulating layer and in the opening; and
   exposing the titanium nitride layer to an ambient atmosphere containing oxygen to cause oxygen molecules to diffuse into the titanium nitride layer.

2. The method of Claim 1, wherein the underlying conductive layer comprises a semiconductor substrate.

3. The method of Claim 1, wherein said step of forming a layer of titanium nitride comprises the step of:
   depositing a layer of substantially stoichiometric titanium nitride over the device.

4. The method of Claim 3, wherein the titanium nitride layer is formed by chemical vapor deposition.

5. The method of Claim 3, wherein said depositing step comprises the steps of:

depositing a layer of titanium in a nonreactive ambient atmosphere;
introducing nitrogen into the ambient atmosphere; and
depositing titanium reacted with the nitrogen to form titanium nitride.

6. The method of Claim 5, wherein the titanium layer is deposited in an atmosphere containing argon.

7. The method of Claim 5, wherein said introducing step further includes introducing oxygen into the ambient atmosphere.

8. The method of Claim 5, further comprising the step of:
   thermally annealing the device after depositing the titanium nitride, wherein titanium silicide is formed in the exposed portion of the underlying conducting layer.

9. The method of Claim 1, wherein said exposing step comprises the step of:
   exposing the titanium nitride layer to an oxygen plasma.

10. The method of Claim 1, wherein said exposing step comprises the step of:
   exposing the titanium nitride layer to an atmosphere containing oxygen and argon at a temperature of between 100 and 500 degrees C.

11. The method of Claim 1, wherein said step of forming the titanium nitride layer comprises the step of:
   providing an ambient atmosphere containing oxygen; and
   depositing the titanium nitride over the device, wherein oxygen atoms are included in the titanium nitride layer.

12. A barrier layer structure for an integrated circuit device, comprising:
   an insulating layer overlying a conductive structure;
   an opening through said insulating layer which exposes a portion of the underlying conductive structure;
   a barrier metal layer overlying a portion of the insulating layer and said opening, said barrier metal layer containing oxygen atoms therein.

13. The structure of Claim 12, wherein said barrier metal layer comprises titanium nitride.

14. The structure of Claim 13, wherein said barrier metal layer comprises substantially stoichiometric titanium nitride throughout its thickness.

15. The structure of Claim 12, wherein said barrier metal layer comprises:

a layer of titanium in contact with said insulating layer and the underlying conductive layer; and

a layer of substantially stoichiometric titanium nitride overlying said titanium layer, said titanium nitride containing oxygen atoms diffused thereinto.

16. The structure of Claim 15, wherein said titanium nitride layer comprises a layer of material formed by sputtering titanium nitride over said titanium layer in an atmosphere containing oxygen.

17. The structure of Claim 15, wherein said titanium nitride layer comprises a layer of material formed by sputtering titanium nitride over said titanium layer in an atmosphere not containing oxygen, followed by diffusing oxygen into said titanium nitride layer from an upper surface thereof.

# Fig. 1

# Fig. 2

# Fig. 3

FIG 4(a)

FIG 4(b)

**FIG 4(a)** flowchart:
BEGIN → SPUTTER TITANIUM IN ARGON (40) → INTRODUCE N₂ AND O₂ (42) → CONTINUE SPUTTERING (44) → END

**FIG 4(b)** flowchart:
BEGIN → DEPOSIT NITRIDE (50) → INTRODUCE OXYGEN PLASMA (52) → EXPOSE TO OXYGEN IN SEPARATE CHAMBER (54) → ANNEAL IN OXYGEN (56) → END

EP 0 545 602 A1

**European Patent Office**

# EUROPEAN SEARCH REPORT

Application Number

EP 92 31 0724

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN vol. 014, no. 222 (E-0926)10 May 1990 & JP-A-20 54 926 ( SEIKO EPSON CORP. ) 23 February 1990 * abstract * | 1-3, 12-13 | H01L21/285 |
| A | | 10,17 | |
| X | PATENT ABSTRACTS OF JAPAN vol. 015, no. 383 (E-1116)27 September 1991 & JP-A-31 53 077 ( SEIKO EPSON CORP ) 1 July 1991 * abstract * | 1-3,9, 12-15 | |
| Y | | 5-7,16 | |
| A | | 8 | |
| Y | PATENT ABSTRACTS OF JAPAN vol. 015, no. 070 (E-1035)19 February 1991 & JP-A-22 91 124 ( FUJITSU LTD ) 30 November 1990 * abstract * | 5-7,16 | |
| | | | **TECHNICAL FIELDS SEARCHED (Int. Cl.5 )** |
| A | PATENT ABSTRACTS OF JAPAN vol. 012, no. 425 (E-681)10 November 1988 & JP-A-63 164 315 ( OKI ELECTRIC IND CO LTD ) 7 July 1977 * abstract * | 4 | H01L |

The present search report has been drawn up for all claims

| Place of search | Date of completion of the search | Examiner |
|---|---|---|
| THE HAGUE | 31 MARCH 1993 | SCHUERMANS N.F. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

8